# EUROPEAN PATENT SPECIFICATION

(11) **EP 3 255 420 B1**
(45) Date of publication and mention of the grant of the patent: **20.11.2019**
(21) Application number: 17175371.8
(22) Date of filing: 09.06.2017
(51) Int. Cl.: G01N 24/00

(54) **METHOD AND APPARATUS FOR ANALYZING A SPUTUM SAMPLE**
VERFAHREN UND GERÄT ZUR DIAGNOSTISCHEN EVALUIERUNG VON SPEICHELPROBEN
MÉTHODE ET APPAREIL POUR EFFECTUER UNE EVALUATION DIAGNOSTIQUE D'ECHANTILLONS D'EXPECTORATIONS

(30) Priority: 10.06.2016 IT UA20164292
(43) Date of publication of application: 13.12.2017
(73) Proprietor: Universita' Degli Studi di Trieste, I-34127 Trieste (IT)
(72) Inventor: Grassi, Gabriele, 34134 Trieste (TS) (IT); Grassi, Mario, 34134 Trieste (TS) (IT); Abrami, Michela, 34138 Trieste (TS) (IT)
(74) Representative: Petraz, Gilberto Luigi

(56) References cited:
- US-A1- 2011 091 987
- US-A1- 2014 220 594
- ERIK J. SAUDE ET AL: "NMR analysis of neutrophil activation in sputum samples from patients with cystic fibrosis", MAGNETIC RESONANCE IN MEDICINE., vol. 52, no. 4, 1 October 2004 (2004-10-01), pages 807-814, XP055319860, US ISSN: 0740-3194, DOI: 10.1002/mrm.20242
- COUDERT J L ET AL: "Preliminary results of nuclear magnetic resonance studies of healthy human saliva", MAGNETIC RESONANCE IN MEDICINE, JOHN WILEY & SONS, INC, US, vol. 10, no. 2, 1 May 1989 (1989-05-01), pages 157-171, XP009128855, ISSN: 0740-3194, DOI: 10.1002/MRM.1910100202 [retrieved on 2005-11-18]
- HANS-PETER HAUBER ET AL: "Mucin Overproduction in Chronic Inflammatory Lung Disease", CANADIAN RESPIRATORY JOURNAL, vol. 13, no. 6, 1 January 2006 (2006-01-01), pages 327-335, XP055319875, CA ISSN: 1198-2241, DOI: 10.1155/2006/901417
- MUTASIM ABU-HASAN ET AL: "Salivary Amylase Level in Bronchoalveolar Fluid as a Marker of Chronic Pulmonary Aspiration in Children", PEDIATRIC ALLERGY, IMMUNOLOGY, AND PULMONOLOGY, vol. 27, no. 3, 1 September 2014 (2014-09-01), pages 115-119, XP055319879, ISSN: 2151-321X, DOI: 10.1089/ped.2014.0348

## Description

### FIELD OF THE INVENTION

Embodiments described here concern a method, and the connected apparatus, for performing an analysis of a sputum sample, commonly referred to as sputum.

In particular, the analysis is intended to identify the pathological condition of subjects affected by pulmonary pathologies such as, for example, microbial-based pulmonary pathologies.

### BACKGROUND OF THE INVENTION

It is known that, in order to detect the pathological condition of a subject affected by a microbial-based pulmonary pathology, in order to evaluate the effect and/or the necessity of a pharmacological therapy, specific analyses of sputum and/or blood cultures must be performed.

Sputum and/or blood cultures need sophisticated measuring equipment and specific equipment for their conservation, which require the intervention of highly specialized personnel and continuous maintenance.

Considering the high number of subjects affected by these pulmonary pathologies, including chronic ones, and the need to perform 8-10 analyses per year for each of them, hospital structures are faced with significant investments to provide this type of service.

In combination with known culture analyses, spirometric measurements are typically also performed which, although they allow to obtain an in-depth picture of the subject's pathological condition, cannot always be performed on particularly weak subjects, such as the elderly, children, or the seriously ill.

A further disadvantage of known analyses, which make use of the above cultures, is that they take about three days to be performed. These performance times, in many cases, can be excessive if compared to the progression times of microbial-based pulmonary pathologies.

US2011/091987 and US2014/220594 disclose detection of microbial components in sputum using hydrogen atom relaxation times measured by NMR.

There is therefore a need to perfect the state of the art and to make available a method, and a connected apparatus, for performing analysis on a sputum sample that overcome at least one of the disadvantages of the state of the art.

In particular, one purpose of the present invention is to provide a method for performing analyses on a sputum sample that allows to obtain an in-depth picture of the pathological condition of a subject affected by pulmonary pathologies in an extremely short time and without using multiple apparatuses and/or cultures of sputum and/or blood.

Another purpose of the present invention is to provide a method for performing analyses on a sputum sample that allows to quickly identify agents such as pathogens and/or other substances present in the sputum sample.

Another purpose of the present invention is to provide an apparatus using the above method for performing analyses of a sputum sample that is economical and does not require highly specialized personnel.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

According to one aspect, a method to carry out analyses on a sputum sample comprising a combination of components, for the identification of a microbial-based pulmonary pathological condition is provided. Said method comprises the following steps:
- making available said sputum sample);
- making available at least one set of reference data associated with different microbial-based pulmonary pathological conditions;
- measuring at least a relaxation time of the hydrogen atoms and an average relaxation time of the hydrogen atoms, said measuring being made by nuclear magnetic resonance unit NMR inducing stresses, by applying magnetic fields having intensities comprised between 0.2T and 2T, to the hydrogen atoms comprised in said sputum sample;
- comparing said average relaxation time and said relaxation times of the hydrogen atoms with said reference data in order to determine the pathological condition associated with said sputum sample;
- supplying information correlated to the pathological condition associated with said sputum sample and correlated to at least part of said components;
wherein said reference data are obtained by means of at least measurements of relaxation times of the hydrogen atoms of said sputum samples with the addition of substances correlated to microbial-based pulmonary pathological conditions, wherein said substances added to said sputum samples are chosen from a group consisting of: bacteria, albumin, alginate, mucin, DNA;
wherein said relaxation time of the hydrogen atoms is correlated to the presence of a component of said sputum sample and said average relaxation time of the hydrogen atoms is correlated to the combination of said components of said sputum sample;
further wherein said method provides information correlated to at least one component by means of a relaxation spectrum consisting of the pairs formed by said relaxation times and of their percentage weights.

According to further aspects, said reference data are further obtained by means of at least one measurement chosen from: measurements of volumes of air exhaled in one second after full-lung inspiration, measurements on blood samples of C-reactive protein and/or neutrophil granulocytes.

According to still a further aspect, an apparatus configured to perform the method of the present invention is provided. The apparatus comprises:
- a feed station configured to make available said sputum sample;
- a memory unit configured to memorize at least one set of reference data associated with different microbial-based pulmonary pathological conditions;
- a measuring station configured to measure at least a relaxation time of the hydrogen atoms and an average relaxation time of the hydrogen atoms of said sputum sample, wherein said measuring station comprises a nuclear magnetic resonance unit NMR configured to induce stresses, by applying magnetic fields having intensities comprised between 0.2T and 2T, to the hydrogen atoms comprised in said sputum sample;
- a processing unit configured to compare the measurements of said relaxation times with at least one of said sets of reference data (14) and to supply at output information correlated to the pathological condition of said sputum sample and to at least part of said components;
wherein said reference data are obtained by means of at least measurements of relaxation times of the hydrogen atoms of said sputum samples with the addition of substances correlated to microbial-based pulmonary pathological conditions, wherein said substances added to said sputum samples are chosen from a group consisting of: bacteria, albumin, alginate, mucin, DNA;
wherein said relaxation time of the hydrogen atoms is correlated to the presence of a component of said sputum sample and said average relaxation time of the hydrogen atoms is correlated to the combination of said components of said sputum sample;
further wherein information is provided which is correlated to at least one component by means of a relaxation spectrum consisting of the pairs formed by said relaxation times and of their percentage weights.

Yet another aspect refers to the use of a measuring station in a method according to the present invention to carry out analyses on a sputum sample able to obtain information correlated to a microbial-based pulmonary pathological condition associated with said sputum sample, wherein said measuring station comprises a nuclear magnetic resonance unit NMR.

### SUMMARY OF OTHER ASPECTS OF THE DISCLOSURE

According to aspects of the disclosure, a method is provided to carry out analyses on a sputum sample comprising at least one component, which provides the following steps:
- making available a sputum sample;
- making available at least one set of reference data associated with different microbial-based pulmonary pathological conditions;
- measuring at least a relaxation time of the hydrogen atoms and an average relaxation time of the hydrogen atoms of the sputum sample;
- comparing the average relaxation time and the relaxation times of the hydrogen atoms with at least one set of reference data supplied in order to determine the pathological condition associated with the sputum sample;
- supplying information correlated to the pathological condition associated with the sputum sample and/or correlated to at least part of its components.

According to aspects of the disclosure, the relaxation times of the hydrogen atoms are correlated to the presence of the components of the sputum sample and the average relaxation time of the hydrogen atoms is correlated to the combination of the components of the sputum sample.

According to aspects of the disclosure, the reference data can comprise data that associate relaxation times on sputum samples containing substances and /or pathogenic agents correlated to a microbial-based pulmonary pathological condition.

According to aspects of the disclosure, the reference data can comprise data measured with one or more techniques chosen from: spirometric measurements, measurements of neutrophil granulocytes, measurements of C-reactive protein levels.

Applicant has verified that there is a surprising and unexpected relation between the relaxation times of the hydrogen atoms present in a sputum sample and the microbial-based pulmonary pathological condition associated with the sputum sample.

This relation has never been observed before and allows to measure the relaxation times of the hydrogen atoms instead of performing costly and complex culture analyses on samples of sputum and/or blood.

Thanks to this method to carry out analyses on a sputum sample it is possible to obtain information correlated to the pathological condition associated with the sputum sample with levels of accuracy comparable with the state of the art, but in much shorter times, that is, execution times comprised between 1 min and 3 mins compared to the almost three days required for cultural analyses.

This allows to effectively monitor the pathological condition and to intervene promptly to prevent the conditions of the subject from worsening.

According to other aspects of the disclosure, it is provided an apparatus connected to said method to carry out analyses of a sputum sample that comprises:
- a feed station configured to make available a sputum sample;
- a memory unit configured to memorize at least one set of reference data associated with different microbial-based pulmonary pathological conditions;
- a measuring station configured to measure at least a relaxation time of the hydrogen atoms and an average relaxation time of the hydrogen atoms of the sputum sample;
- a processing unit configured to compare the measurements of the relaxation times with at least one sets of reference data and to supply at output information correlated to the pathological condition of the sputum sample and/or to at least part of its components.

According to aspects of the disclosure, the measuring station can comprise a nuclear magnetic resonance unit also called NMR, configured to induce a stress, by applying magnetic fields, to the hydrogen atoms comprised in the sputum sample.

According to aspects of the disclosure, the magnetic fields used by the NMR unit can be comprised between 0.2T and 2T and allow to detect the average relaxation time of the hydrogen atoms in the sputum sample, for example, of the water contained in the sputum sample.

These and other aspects, characteristics and advantages of the present disclosure will be better understood with reference to the following description, drawings and attached claims. The drawings, which are integrated and form part of the present description, show some forms of embodiment of the present invention, and together with the description, are intended to describe the principles of the disclosure.

The various aspects and characteristics described in the present description can be applied individually where possible. These individual aspects, for example aspects and characteristics described in the attached dependent claims, can be the object of divisional applications.

It is understood that any aspect or characteristic that is discovered, during the patenting process, to be already known, shall not be claimed and shall be the object of a disclaimer.

### BRIEF DESCRIPTION OF THE DRAWINGS

These and other characteristics of the present invention will become apparent from the following description of some embodiments, given as a non-restrictive example with reference to the attached drawings wherein:
- fig. 1 schematically shows an apparatus to carry out analyses of a sputum sample according to the present description;
- figs. 2-3 are two graphs that show a functional relation between average relaxation times and the pathological condition of a subject according to the present description;
- figs. 4-7 are four graphs that show four functional relations according to the present description;
- fig. 8 is a graph that shows the correlation of the relaxation times of the hydrogen atoms with some components of a sputum sample according to the present description;
- fig. 9 is a graph that shows the relation between the average relaxation time of the hydrogen atoms and the pathological condition according to the present description.

To facilitate comprehension, the same reference numbers have been used, where possible, to identify identical common elements in the drawings. It is understood that elements and characteristics of one embodiment can conveniently be incorporated into other embodiments without further clarifications.

### DETAILED DESCRIPTION OF SOME EMBODIMENTS

We shall now refer in detail to the various embodiments of the present invention, of which one or more examples are shown in the attached drawings. Each example is supplied by way of illustration of the invention and shall not be understood as a limitation thereof. For example, the characteristics shown or described insomuch as they are part of one embodiment can be adopted on, or in association with, other embodiments to produce another embodiment. It is understood that the present invention shall include all such modifications and variants.

Before describing these embodiments, we must also clarify that the present description is not limited in its application to details of the construction and disposition of the components as described in the following description using the attached drawings. The present description can provide other embodiments and can be obtained or executed in various other ways. We must also clarify that the phraseology and terminology used here is for the purposes of description only, and cannot be considered as limitative. The use of terms such as "including", "comprising", "having" and their variations is intended to include the elements listed after them and their equivalents, and also additional elements. The expressions "which has" and "which provides" must be understood non-exhaustively, unless the context suggests otherwise.

Unless otherwise defined, all the technical and scientific terms used here and hereafter have the same meaning as commonly understood by a person with ordinary experience in the field of the art to which the present invention belongs. Even if methods and materials similar or equivalent to those described here can be used in practice and in the trials of the present invention, the methods and materials are described hereafter as an example. In the event of conflict, the present application shall prevail, including its definitions. The materials, methods and examples have a purely illustrative purpose and shall not be understood restrictively.

All the intervals reported here shall be understood to include the extremes, including those that report an interval "between" two values, unless otherwise indicated.

The present description also includes the intervals that derive from uniting or overlapping two or more intervals described, unless otherwise indicated.

The present description also includes the intervals that can derive from the combination of two or more values taken at different points, unless otherwise indicated.

Terms such as "about", "generally", "substantially" and suchlike shall be understood with their function of modifying a term or value that is not absolute, but is not reported in the state of the art. Such terms shall be defined by the specific circumstances and by the terms that they are intended to modify according to the common acceptance of such terms in the specific field. They shall take into account at least the degree of experimental error expected, the technical error and the instrumental error for a given technique adopted to measure a value. Unless otherwise indicated, in the present description, singular forms such as "a", "an" and "one" shall be understood to include plural forms, unless the context suggests otherwise.

Embodiments described here concern a method and connected apparatus 10 for the analysis of a sputum sample 11 able to identify a possible association with a microbial-based pulmonary pathological condition.

The method provides to use quantities limited to a few milliliters of sputum sample 11, which are significantly less than or comparable to the quantities normally expelled, for example with a coughing fit or salivation, by subjects affected by microbial-based lung diseases, such as for example cystic fibrosis or other pathologies.

This allows to make available sputum samples 11 while completely excluding from the method any steps that comprise actions and/or operations on and/or involving a subject.

According to one aspect of the present description, an apparatus 10 for performing analyses of a sputum sample 11 is provided that comprises:
- a feed station 12 configured to make available a sputum sample 11;
- a memory unit 13 configured to memorize at least one set of reference data 14 obtained by measuring at least one chemical-physical parameter of a plurality of samples of various nature associated with different microbial-based pulmonary pathological conditions;
- a measuring station 15 configured to measure at least a relaxation time T₂ᵢ of the hydrogen atoms and an average relaxation time T₂ₘ of the hydrogen atoms of the sputum sample 11;
- a processing unit 16 configured to compare the measurements of the relaxation times T₂ᵢ and T₂ₘ of the hydrogen atoms obtained by the measuring station 15 with at least one set of reference data 14 memorized in the memory unit 13, and to supply at output information 17 correlated to the pathological condition of the sputum sample 11 and/or to at least part of its components Cᵢ.

According to aspects of the disclosure, the relaxation times T₂ᵢ of the hydrogen atoms can be correlated to the presence of a component Cᵢ of the sputum sample 11 and the average relaxation time T₂ₘ of the hydrogen atoms can be correlated to the set of components Cᵢ of the sputum sample 11.

By sputum sample 11 we mean a sample comprising mucus, saliva which, according to the pulmonary pathology condition associated with it, can also comprise other components Cᵢ including: bacteria such as, for example, Pseudomonas Aeruginosa, Staphylococcus Aureus, or other bacteria, alginates, mucin, DNA.

The concentrations of components Cᵢ depend on the pathological pulmonary condition, in particular they are higher in microbial-based pathological pulmonary cases compared to a sputum sample 11 of a healthy subject.

According to aspects of the disclosure, the feed station 12 can include a feed device configured to contain at least one container in which a sputum sample 11 is contained.

The feed device can be provided with a motorized transfer unit configured to position the container with the sputum sample 11 in a defined measuring position of the measuring station 15.

According to aspects of the disclosure, the measuring station 15 can comprise a nuclear magnetic resonance unit, also called an NMR unit 18, configured to induce stresses, by applying magnetic fields, on the hydrogen atoms comprised in the sputum sample 11.

The operating principle is based on the orientation of the dipole moment of the hydrogen atoms when subjected to a magnetic field. In particular, the NMR unit 18 is configured to apply a first magnetic field in a predetermined direction, in which the dipole moments of the hydrogen atoms are substantially oriented.

The NMR unit 18 is able to apply a second magnetic field orthogonal to the predetermined direction and more intense than the first magnetic field. As a result of the application of the second magnetic field, the dipole moments of the hydrogen atoms will be oriented substantially in the direction of the second magnetic field.

By removing the second magnetic field, the dipole moments are again aligned in the predetermined direction at a specific time: this time is also referred to as the average relaxation time of the dipole moments of the hydrogen atoms T₂ₘ.

The average relaxation time T₂ₘ is a function of the relaxation times of the hydrogen atoms T₂ᵢ based on their percentage weight Aᵢ.

The set of pairs T₂ᵢ-Aᵢ constitutes the relaxation spectrum of the sputum sample 11 under examination and, according to the present description, can be used to identify the components Cᵢ contained in the sputum sample 11.

According to aspects of the disclosure, the magnetic fields used by the NMR unit 18 can be comprised between 0.2T and 2T. As will be clear hereafter in the description, this range is functional in identifying which components Cᵢ contribute and to what extent to determine the average T₂ₘ relaxation time measured.

The Applicant has studied and verified the dependence of the average relaxation time T₂ₘ and the spectrum of T₂ᵢ-Aᵢ pairs depending on the pathological condition associated with various sputum samples 11.

In particular, it has been verified that the average relaxation time T₂ₘ is greatly dependent on the presence of bacteria, their products, such as alginates, mucus, inflammatory cells and other substances possibly present in microbial pulmonary pathological conditions.

This dependence was not expected in the light of the fact it was not possible to imagine that the presence of the components Cᵢ would so much influence the relaxation time T₂ₘ and T₂ᵢ of the hydrogens present in the sputum.

In particular, the presence of components Cᵢ influences the relaxation times associated with the water molecules contained in the sputum sample 11.

Depending on the severity of the pathological condition associated with the sputum sample 11, it was observed that the average relaxation time T₂ₘ is inversely proportional to the severity of the pathological condition.

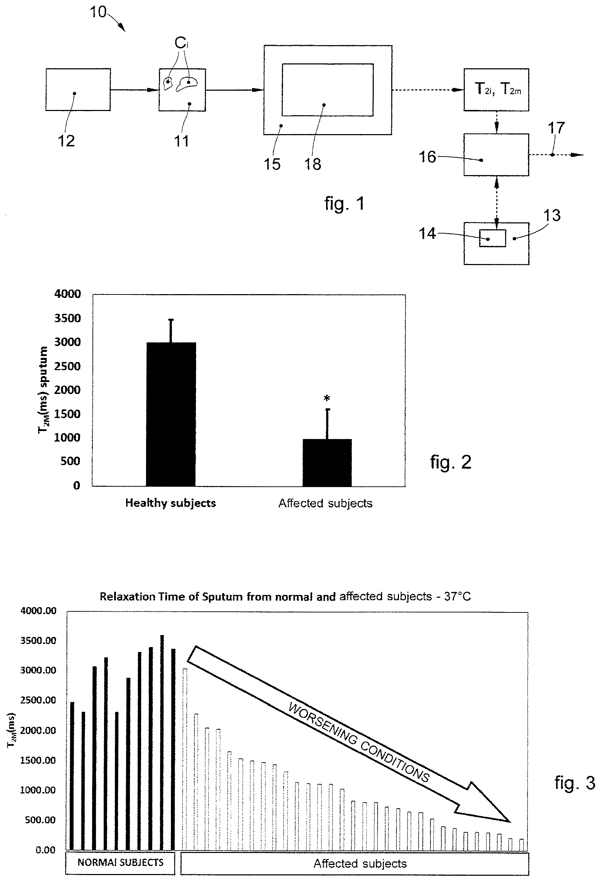

With reference to figs. 2-3, the Applicant has verified that a strong dependence on the average relaxation time T₂ₘ is obvious, depending on the pathological condition, and in particular as much as a tenfold variation has been observed compared to the average relaxation time T₂ₘ associated with a healthy condition.

In order to make the measurements of the average relaxation time T₂ₘ reliable and accurate, the measurements can advantageously be correlated with at least a set of reference data 14 obtained by measuring at least one chemical-physical parameter of a plurality of samples of various nature, for example samples of blood and/or sputum and/or spirometric quantities obtained from measurements of the functional capacity of the lungs.

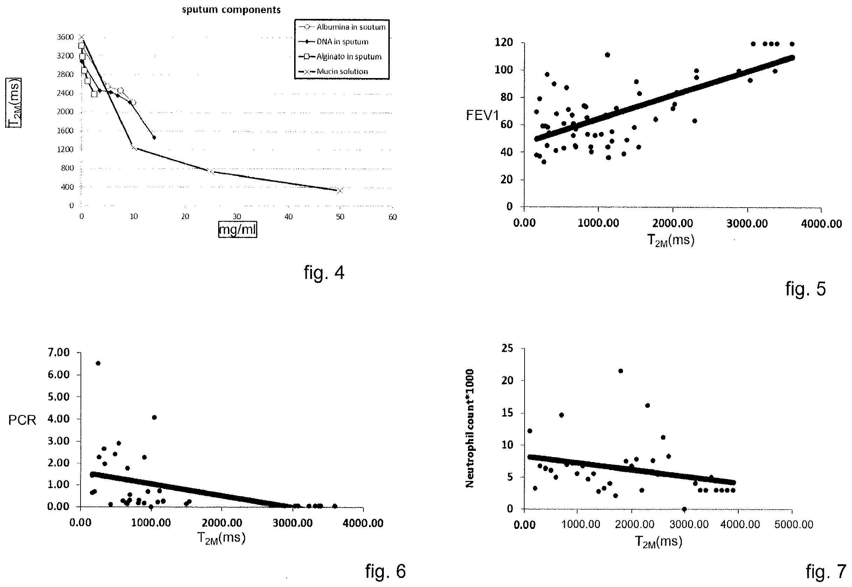

According to aspects of the disclosure, the set of reference data 14 can comprise data obtained from spirometric measurements, such as measurements of the volume of air exhaled in one second after filling the lungs FEV₁ (fig. 5), data obtained from measurements of relaxation times of the atoms of hydrogen T₂ᵢ and T₂ₘ of sputum samples 11 with the addition of substances correlated to microbial-based pulmonary pathological conditions (fig. 4), data obtained from measurements on blood samples of C-reactive protein (fig. 6) and/or neutrophil granulocytes (fig. 7), the trend of which is functional to the inflammatory condition of subjects affected by microbial-based pulmonary pathologies.

According to aspects of the disclosure, the substances added to the sputum samples 11 can comprise bacteria, albumin, alginate, mucin, DNA, or other substances associated with a microbial-based pulmonary pathological condition.

According to aspects of the disclosure, the set of reference data 14 allows to correlate more accurately the pathological conditions associated with the various sputum samples 11 to the measurements of the relaxation times T₂ᵢ and T₂ₘ so that by measuring such times it is possible to identify the pathological condition with great reliability.

According to aspects of the disclosure, at least one set of reference data 14 can be memorized in a memory unit 13 so that it can be consulted to identify the pathological condition of a measured sputum sample 11.

Once the reference data 14 have been memorized in the memory unit 13, this means that it is no longer necessary to have to resort to further cultural analyses of blood and/or sputum samples which, as is known, present many problems.

According to aspects of the disclosure, the memory unit 13 and the processing unit 16 can comprise an electronic circuit, a microprocessor, a data processing terminal or other similar or comparable devices configured respectively to memorize reference data 14 and compare the measured relaxation times T₂ₘ and T₂ᵢ with memorized reference data 14.

In particular, the processing unit 16 can provide output information 17, for example in the form of an electrical signal or a set of data, correlated to the pathological condition of the measured sputum sample 11.

According to one of the aspects of the present disclosure, from the comparison between the measured relaxation times and the memorized reference data 14, it is also possible to obtain information 17, correlated with at least part of the components Cᵢ of the sputum sample 11.

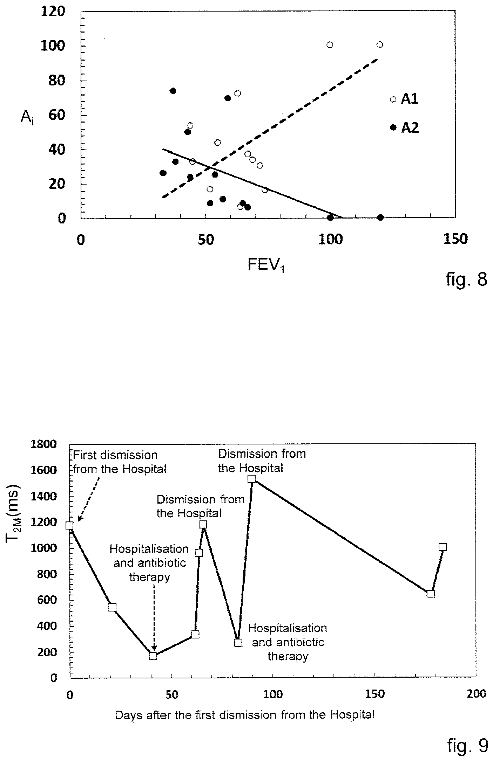

With reference to the non-restrictive example of fig. 8, four relaxation times T₂ᵢ correlated to the presence of Pseudomonas Aeruginosa in a sputum sample 11 were identified.

In this case, the relaxation spectrum T₂ᵢ-Aᵢ inferred from various sputum samples 11 is as follows: 2200ms-34.4%, 1200ms-39.5%, 470ms-39.5%, 180ms-30.5%.

In this case, although the average relaxation time T₂ₘ measured is proportional to the increase in the values of the exhaled air volume FEV₁, two of the four components, that is, A₁ and A₂, follow different trends.

Therefore, by analyzing the relaxation spectrum T₂ᵢ-Aᵢ it is possible to identify which specific bacterium or other component Cᵢ is present in the sputum sample 11.

In other words, in order to obtain information 17 correlated to the specific components Cᵢ contained in a sputum sample 11, in addition to the average relaxation time T₂ₘ, the method also provides to measure the relaxation spectrum T₂ᵢ-Aᵢ.

According to one aspect of the present disclosure, the method for analyzing a sputum sample 11 comprises the following steps:
- making available a sputum sample 11;
- making available at least one set of reference data 14 obtained by measuring at least one chemical-physical parameter of a plurality of samples of various nature associated with different microbial-based pulmonary pathological conditions;
- measuring at least one relaxation time of the hydrogen atoms T₂ᵢ and the average relaxation time of the hydrogen atoms T₂ₘ of the sputum sample 11;
- comparing the average relaxation time T₂ₘ and the relaxation times of the hydrogen atoms T₂ᵢ with at least one set of reference data 14 supplied to determine the pathological condition associated with the sputum sample 11;
- supplying information 17 correlated to the pathological condition associated with the sputum sample 11 and with at least part of its components Cᵢ.

According to a aspects of the disclosure, the relaxation times T₂ᵢ of the hydrogen atoms can be correlated to the presence of the components Cᵢ of the sputum sample 11 and the average relaxation time T₂ₘ of the hydrogen atoms can be correlated to the set of the components Cᵢ of the sputum sample 11.

According to one aspect of the present disclosure, the method for performing analyses on a sputum sample 11 allows to obtain information 17 correlated to the pathological condition associated with the sputum sample 11 with levels of accuracy comparable to the state of the art but much more quickly, that is, performance times of less than 5min, more particularly between 1min and 3min, against the approximately three days required for known culture analyses.

This advantage is possible thanks both to the performance speed of the measurements of the relaxation times T₂ᵢ and T₂ₘ and also to the fact that the reference data 14 memorized in the memory unit 13 allow to quickly identify with which pathological condition the sputum sample 11 analyzed is associated.

This allows to effectively monitor the pathological condition and to intervene promptly to prevent the subject's condition from worsening. For example, fig. 9 shows a monitoring performed on a subject by measuring the average relaxation times T₂ₘ of sputum samples 11 subsequently made available.

From this type of data it is also possible to determine the evolutionary times of microbial-based pulmonary pathologies for a specific subject, and then to promptly program and actuate the interventions needed for his/her recovery.

## Claims

1. Method to carry out analyses on a sputum sample (11) comprising a combination of components (Cᵢ), for the identification of a microbial-based pulmonary pathological condition, said method comprising the following steps:
- making available said sputum sample (11);
- making available at least one set of reference data (14) associated with different microbial-based pulmonary pathological conditions;
- measuring at least a relaxation time of the hydrogen atoms (T₂ᵢ) and an average relaxation time of the hydrogen atoms (T₂ₘ), said measuring being made by nuclear magnetic resonance unit NMR inducing stresses, by applying magnetic fields having intensities comprised between 0.2T and 2T, to the hydrogen atoms comprised in said sputum sample (11);
- comparing said average relaxation time (T₂ₘ) and said relaxation times of the hydrogen atoms (T₂ᵢ) with said reference data (14) in order to determine the pathological condition associated with said sputum sample (11);
- supplying information (17) correlated to the pathological condition associated with said sputum sample (11) and correlated to at least part of said components (Cᵢ);
wherein said reference data (14) are obtained by means of at least measurements of relaxation times of the hydrogen atoms (T₂ᵢ, T₂ₘ) of said sputum samples (11) with the addition of substances correlated to microbial-based pulmonary pathological conditions, wherein said substances added to said sputum samples (11) are chosen from a group consisting of: bacteria, albumin, alginate, mucin, DNA;
wherein said relaxation time of the hydrogen atoms (T₂ᵢ) is correlated to the presence of a component (Cᵢ) of said sputum sample (11) and said average relaxation time of the hydrogen atoms (T₂ₘ) is correlated to the combination of said components (Cᵢ) of said sputum sample (11);
further wherein said method provides information (17) correlated to at least one component (Cᵢ) by means of a relaxation spectrum (T₂ᵢ-Aᵢ) consisting of the pairs formed by said relaxation times (T₂ᵢ) and of their percentage weights (Aᵢ).

2. Method as in claim 1, **characterized in that** said reference data (14) are further obtained by means of at least one measurement chosen from:
measurements of volumes of air exhaled in one second after full-lung inspiration (FEV₁), measurements on blood samples of C-reactive protein and/or neutrophil granulocytes.

3. Apparatus configured to perform a method according to claims 1 or 2, said apparatus comprising- a feed station (12) configured to make available said sputum sample (11);
- a memory unit (13) configured to memorize at least one set of reference data (14) associated with different microbial-based pulmonary pathological conditions;
- a measuring station (15) configured to measure at least a relaxation time (T₂ᵢ) of the hydrogen atoms and an average relaxation time (T₂ₘ) of the hydrogen atoms of said sputum sample (11), wherein said measuring station (15) comprises a nuclear magnetic resonance unit NMR (18) configured to induce stresses, by applying magnetic fields having intensities comprised between 0.2T and 2T, to the hydrogen atoms comprised in said sputum sample (11);
- a processing unit (16) configured to compare the measurements of said relaxation times (T₂ᵢ, T₂ₘ) with at least one of said sets of reference data (14) and to supply at output information (17) correlated to the pathological condition of said sputum sample (11) and to at least part of said components (Cᵢ);
wherein said reference data (14) are obtained by means of at least measurements of relaxation times of the hydrogen atoms (T₂ᵢ, T₂ₘ) of said sputum samples (11) with the addition of substances correlated to microbial-based pulmonary pathological conditions, wherein said substances added to said sputum samples (11) are chosen from a group consisting of: bacteria, albumin, alginate, mucin, DNA;
wherein said relaxation time of the hydrogen atoms (T₂ᵢ) is correlated to the presence of a component (Cᵢ) of said sputum sample (11) and said average relaxation time of the hydrogen atoms (T₂ₘ) is correlated to the combination of said components (Cᵢ) of said sputum sample (11);
further wherein information (17) is provided which is correlated to at least one component (Cᵢ) by means of a relaxation spectrum (T₂ᵢ-Aᵢ) consisting of the pairs formed by said relaxation times (T₂ᵢ) and of their percentage weights (Aᵢ).

4. Use of a measuring station (15) in a method according to claim 1 or 2 to carry out analyses on a sputum sample (11) able to obtain information (17) correlated to a microbial-based pulmonary pathological condition associated with said sputum sample (11), wherein said measuring station (15) comprises a nuclear magnetic resonance unit NMR (18).

## Patentansprüche

1. Verfahren zur Durchführung von Analysen an einer Sputumprobe (11), enthaltend eine Kombination von Komponenten (Cᵢ), zur Identifikation eines mikrobiell basierten Lungenpathologiezustands, wobei das besagte Verfahren die folgenden Schritte umfasst:
- Bereitstellen der besagten Sputumprobe (11);
- Bereitstellen mindestens eines Referenzdatensatzes (14), der mit verschiedenen mikrobiell basierten Lungenpathologiezuständen assoziiert ist;
- Messen mindestens einer Relaxationszeit der Wasserstoffatome (T₂ᵢ) und einer durchschnittlichen Relaxationszeit der Wasserstoffatome (T₂ₘ), wobei die besagte Messung mittels einer Kernspinresonanzeinheit NMR gemacht wird, welche, auf die in der besagten Sputumprobe (11) enthalten Wasserstoffatome Stress induziert, indem Magnetfelder mit Intensitäten enthalten zwischen 0,2T und 2T angelegt werden;
- Vergleichen der besagten durchschnittlichen Relaxationszeit (T₂ₘ) und den besagten Relaxationszeiten der Wasserstoffatome (T₂ᵢ) mit den besagten Referenzdaten (14), um den mit der besagten Sputumprobe (11) assoziierten pathologischen Zustand zu bestimmen;
- Bereitstellen von Informationen (17), die mit dem pathologischen Zustand korreliert sind, der mit der besagten Sputumprobe (11) assoziiert ist, und die mit mindestens einem Teil der besagten Komponenten (Ci) korreliert sind;
wobei die besagten Referenzdaten (14) erhalten werden mindestens mittels Messungen der Relaxationszeiten der Wasserstoffatome (T₂ᵢ, T₂ₘ) der besagten Sputumproben (11) unter Zugabe von Substanzen, die mit mikrobiell basierten Lungenpathologiezuständen korreliert sind, wobei die den besagten Sputumproben (11) zugegebenen besagten Substanzen ausgewählt sind aus einer Gruppe bestehend aus:
Bakterien, Albumin, Alginat, Mucin, DNA;
wobei die besagte Relaxationszeit der Wasserstoffatome (T₂ᵢ) mit dem Vorhandensein einer Komponente (Cᵢ) der besagten Sputumprobe (11) korreliert ist und die besagte durchschnittliche Relaxationszeit der Wasserstoffatome (T₂ₘ) mit der Kombination der besagten Komponenten (Cᵢ) der besagten Sputumprobe (11) korreliert ist;
ferner, wobei das besagte Verfahren Informationen (17) bereitstellt, die mit mindestens einer Komponente (Cᵢ) korreliert sind, mittels eines Relaxationsspektrums (T₂ᵢ-Aᵢ), bestehend aus den durch die besagten Relaxationszeiten (T₂ᵢ) und ihren prozentualen Gewichten (Aᵢ) gebildeten Paaren.

2. Verfahren wie in Anspruch 1, **dadurch gekennzeichnet, dass** die besagten Referenzdaten (14) ferner mittels mindestens einer Messung erhalten werden, ausgewählt aus:
Messungen der Luftvolumen die nach voller Lungen Inspiration in einer Sekunde ausgeatmet werden (FEV₁), Messungen an Blutproben von C-reaktivem Protein und/oder neutrophilen Granulozyten.

3. Vorrichtung, ausgelegt, um ein Verfahren gemäß den Ansprüchen 1 oder 2 auszuführen, die besagte Vorrichtung enthaltend:
- eine Zuführstation (12), ausgelegt, um die besagte Sputumprobe (11) bereit zu stellen;
- eine Speichereinheit (13), ausgelegt, um mindestens einen Referenzdatensatz (14) zu speichern, der mit verschiedenen mikrobiell basierten Lungenpathologiezuständen assoziiert ist;
- eine Messstation (15), ausgelegt, um mindestens eine Relaxationszeit (T₂ᵢ) der Wasserstoffatome und eine durchschnittliche Relaxationszeit (T₂ₘ) der Wasserstoffatome der besagten Sputumprobe (11) zu messen, wobei die besagte Messstation (15) eine Kernspinresonanzeinheit NMR (18) enthält, ausgelegt, um, durch Anlegen von Magnetfeldern mit Intensitäten enthalten zwischen 0,2T und 2T auf die in der besagten Sputumprobe (11) enthaltenen Wasserstoffatome Stress zu induzieren;
- eine Verarbeitungseinheit (16), ausgelegt, um die Messungen der besagten Relaxationszeiten (T₂ᵢ, T₂ₘ) mit mindestens einem der besagten Referenzdatensätze (14) zu vergleichen und als Ergebnis Informationen (17) bereitzustellen, die mit dem pathologischen Zustand der besagten Sputumprobe (11) und mindestens einem Teil der Komponenten (Cᵢ) korreliert sind;
wobei die besagten Referenzdaten (14) erhalten werden mindestens mittels Messungen der Relaxationszeiten der Wasserstoffatome (T₂ᵢ, T₂ₘ) der besagten Sputumproben (11) unter Zugabe von Substanzen, die mit mikrobiell basierten Lungenpathologiezuständen korreliert sind, wobei die den besagten Sputumproben (11) zugegebenen besagten Substanzen ausgewählt sind aus einer Gruppe bestehend aus:
Bakterien, Albumin, Alginat, Mucin, DNA;
wobei die besagte Relaxationszeit der Wasserstoffatome (T₂ᵢ) mit dem Vorhandensein einer Komponente (Cᵢ) der besagten Sputumprobe (11) korreliert ist und die besagte durchschnittliche Relaxationszeit der Wasserstoffatome (T₂ₘ) mit der Kombination der besagten Komponenten (Cᵢ) der besagten Sputumprobe (11) korreliert ist;
ferner, wobei Information (17) bereitgestellt wird, die mit mindestens einer Komponente (Cᵢ) korreliert ist, mittels eines Relaxationsspektrums (T₂ᵢ-Aᵢ), bestehend aus den durch die besagten Relaxationszeiten (T₂ᵢ) und ihren prozentualen Gewichten (Aᵢ) gebildeten Paaren.

4. Verwendung einer Messstation (15) in einem Verfahren nach Anspruch 1 oder 2, um Analysen an einer Sputumprobe (11) durchzuführen, geeignet um Information (17) zu erhalten, die mit einem mikrobiell basierten Lungenpathologiezustand korreliert ist, der mit der besagten Sputumprobe (11) assoziiert ist, wobei die besagte Messstation (15) eine Kernspinresonanzeinheit NMR (18) enthält.

## Revendications

1. Méthode pour effectuer des analyses sur un échantillon d'expectoration (11) comprenant une combinaison de composants (Cᵢ), pour l'identification d'une condition pathologique pulmonaire à base microbienne, ladite méthode comprenant les étapes suivantes :
- mettre à disposition ledit échantillon d'expectoration (11) ;
- mettre à disposition au moins un ensemble de données de référence (14) associées à différentes conditions pathologiques pulmonaires à base microbienne ;
- mesurer au moins un temps de relaxation des atomes d'hydrogène (T₂ᵢ) et un temps de relaxation moyen des atomes d'hydrogène (T₂ₘ), ledit mesurage étant réalisée par des unités de résonance magnétique nucléaire RMN induisant des sollicitations, en appliquant des champs magnétiques d'intensités comprises entre 0,2T et 2T, aux atomes d'hydrogène compris dans ledit échantillon d'expectoration (11) ;
- comparer ledit temps de relaxation moyen (T₂ₘ) et lesdits temps de relaxation des atomes d'hydrogène (T₂ᵢ) avec lesdites données de référence (14) afin de déterminer la condition pathologique associée audit échantillon d'expectoration (11) ;
- fournir des informations (17) corrélées à la condition pathologique associée audit échantillon d'expectoration (11) et corrélées au moins à une partie desdits composants (Ci) ;
où lesdites données de référence (14) sont obtenues au moyen d'au moins des mesurages de temps de relaxation des atomes d'hydrogène (T₂ᵢ, T₂ₘ) desdits échantillons d'expectoration (11) avec l'ajout de substances corrélées à des conditions pathologiques pulmonaires à base microbienne, où lesdites substances ajoutées auxdits échantillon d'expectoration (11) sont choisies dans un groupe comprenant : bactéries, albumine, alginate, mucine, ADN ;
où ledit temps de relaxation des atomes d'hydrogène (T₂ᵢ) est corrélé à la présence d'un composant (Cᵢ) dudit échantillon d'expectoration (11) et ledit temps de relaxation moyen des atomes d'hydrogène (T₂ₘ) est corrélé à la combinaison desdits composants (Cᵢ) dudit échantillon d'expectoration (11) ;
où ladite méthode fournit en outre des informations (17) corrélées au moins à un composant (Cᵢ) au moyen d'un spectre de relaxation (T₂ᵢ-Aᵢ) constitué des paires formées par lesdits temps de relaxation (T₂ᵢ) et des leurs pourcentages en poids (Aᵢ).

2. Méthode selon la revendication 1, **caractérisée par le fait que** lesdites données de référence (14) sont en outre obtenues au moyen d'au moins un mesurage choisie parmi :
des mesurages de volumes d'air expirés en une seconde après inspiration pulmonaire totale (FEV₁), des mesurages sur des échantillons de sang de la protéine C réactive et/ou des granulocytes neutrophiles.

3. Appareil configuré pour exécuter une méthode selon les revendications 1 ou 2, ledit appareil comprenant: - une station d'alimentation (12) configurée pour rendre disponible ledit échantillon d'expectoration (11) ;
- une unité de mémoire (13) configurée pour mémoriser au moins un ensemble de données de référence (14) associées à différentes conditions pathologiques pulmonaires à base microbienne ;
- une station de mesurage (15) configurée pour mesurer au moins un temps de relaxation (T₂ᵢ) des atomes d'hydrogène et un temps de relaxation moyen (T₂ₘ) des atomes d'hydrogène dudit échantillon d'expectoration (11), où ladite station de mesurage (15) comprend une unité de résonance magnétique nucléaire RMN (18) configurée pour induire des sollicitations, en appliquant des champs magnétiques d'intensités comprises entre 0,2T et 2T, aux atomes d'hydrogène compris dans ledit échantillon d'expectoration (11) ;
- une unité de traitement (16) configurée pour comparer les mesures desdits temps de relaxation (T₂ᵢ, T₂ₘ) avec au moins un desdits ensembles de données de référence (14) et pour fournir des informations de sortie (17) corrélées à la condition pathologique dudit échantillon d'expectoration (11) et sur au moins une partie desdits composants (Cᵢ) ;
où lesdites données de référence (14) sont obtenues au moyen d'au moins des mesurages de temps de relaxation des atomes d'hydrogène (T₂ᵢ, T₂ₘ) desdits échantillons d'expectoration (11) avec l'ajout de substances corrélées à des conditions pathologiques pulmonaires à base microbienne, où lesdites substances ajoutées auxdits échantillon d'expectoration (11) sont choisies dans un groupe comprenant : bactéries, albumine, alginate, mucine, ADN ;
où ledit temps de relaxation des atomes d'hydrogène (T₂ᵢ) est corrélé à la présence d'un composant (Cᵢ) dudit échantillon d'expectoration (11) et ledit temps de relaxation moyen des atomes d'hydrogène (T₂ₘ) est corrélé à la combinaison desdits composants (Cᵢ) dudit échantillon d'expectoration (11) ;
où sont en outre fournies lesdites informations (17) qui sont corrélées au moins à un composant (Cᵢ) au moyen d'un spectre de relaxation (T₂ᵢ-Aᵢ) constitué des paires formées par lesdits temps de relaxation (T₂ᵢ) et des leurs pourcentages en poids (Aᵢ).

4. Utilisation d'une station de mesurage (15) dans une méthode selon la revendication 1 ou 2 pour effectuer des analyses sur un échantillon d'expectoration (11) capable d'obtenir des informations (17) corrélées à une condition pathologiques pulmonaires à base microbienne associée audit échantillon d'expectoration (11), où ladite station de mesurage (15) comprend une unité de résonance magnétique nucléaire RMN (18).
